Europäisches Patentamt

(19) European Patent Office

Office européen des brevets

(11) EP 0 911 971 A1

(12) EUROPEAN PATENT APPLICATION

(43) Date of publication:
28.04.1999 Bulletin 1999/17

(51) Int. Cl.$^6$: H03K 5/135

(21) Application number: 98303807.6

(22) Date of filing: 14.05.1998

(84) Designated Contracting States:
AT BE CH CY DE DK ES FI FR GB GR IE IT LI LU
MC NL PT SE
Designated Extension States:
AL LT LV MK RO SI

(30) Priority: 21.10.1997 JP 288946/97

(71) Applicant: FUJITSU LIMITED
Kawasaki-shi, Kanagawa 211-8588 (JP)

(72) Inventor: Isoda, Yutaka
Nakahara-ku, Kawasaki-shi, Kanagawa 211 (JP)

(74) Representative:
Stebbing, Timothy Charles et al
Haseltine Lake & Co.,
Imperial House,
15-19 Kingsway
London WC2B 6UD (GB)

(54) Clock switching apparatus

(57) A clock switching apparatus in which a switching order of clocks (CLK1-CLK3) is held according to a clear clock signal (FCC) indicating a change in input clock selection signals in a switching/holding circuit (2), a reference clock signal (BCLK) is generated according to input clock source signals (two signals out of three signals) before and after switching based on the switching order in a reference clock generator (3), a clock selection signal is generated by synchronizing the clear clock signal to the reference clock signal in a synchronizing circuit (4), and clock switching is executed at a timing of generating the clock selection signal in a clock switching circuit (5).

FIG.1

## Description

The present invention relates to a clock switching apparatus, and more particularly to a clock switching apparatus for switching a plurality of clock signals asynchronous to each other and each having a different phase according to a clock selection signal.

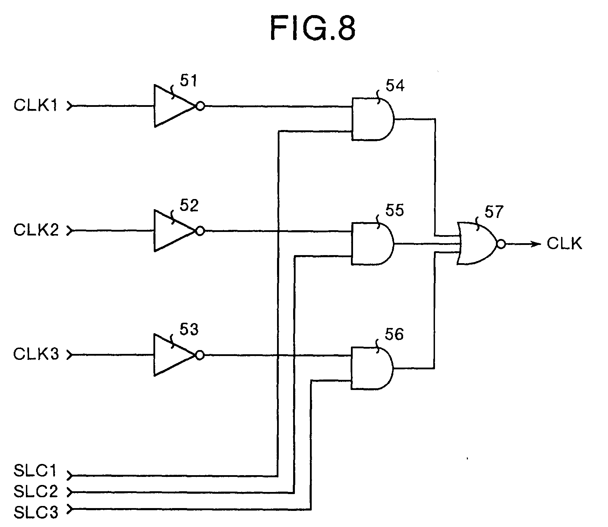

Fig. 8 is a circuit block diagram showing internal configuration of a clock switching apparatus based on a conventional technology. Fig. 8 shows a clock switching apparatus for switching clocks according to three types of input clock selection signals SLC1 to SLC3 being correlated one versus one to three types of input clock source signals CLK1 to CLK3 asynchronous to each other and each having a different phase.

This clock switching apparatus comprises inverters 51 to 53 for inverting and outputting input clock source signals CLK1 to CLK3 respectively, AND circuits 54 to 56 for computing a logical product between output from the inverters 51 to 53 and input clock selection signals SLC1 to SLC3 in response to the input clock source signals CLK1 to CLK3 respectively, and a NOR circuit 57 for executing a NOR operation for outputs from the AND circuits 54 to 56 and outputting a clock signal CLK for system supply.

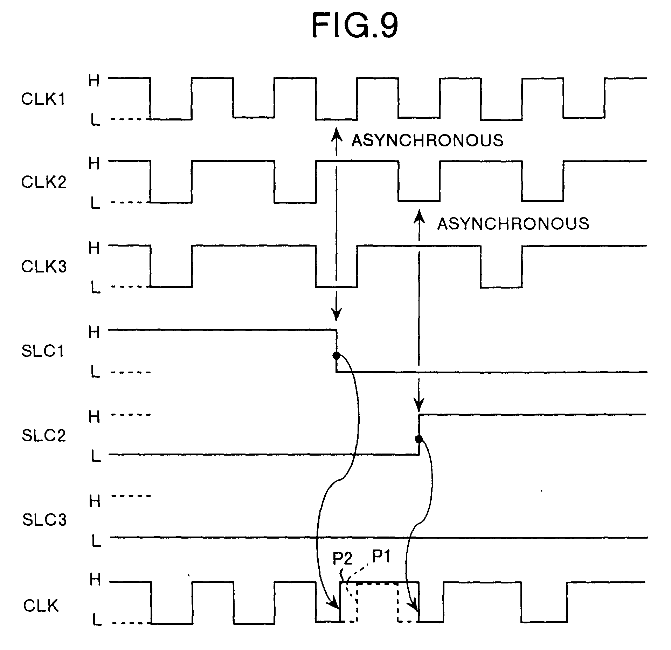

Next description is made of the operation. Description assumes herein a case of an operation for switching to an input clock source signal CLK2 when an input clock source signal CLK1 has been selected. Fig. 9 is a timing chart showing an example of operations in the circuits shown in Fig. 8. It is assumed in the clock switching apparatus in Fig. 8 that a change of signals before and after switching among the input clock selection signals SLC1 to SLC3 is executed in the asynchronous mode. Namely, there is a time gap, at the time of switching from the input clock source signal CLK1 to the input clock source signal CLK2, between a timing when the input clock selection signal SLC1 is changed from "H" (high) level to "L" (low) level and a timing when the input clock selection signal SLC2 is changed from "L" level to "H" level.

The input clock source signals CLK1, CLK2, CLK3 are inverted by the corresponding inverters 51, 52, 53, and then outputted to the AND circuits 54, 55, and 56 respectively. Inputted into the AND circuit 54, for example, are an inverted signal of an input clock source signal CLK1 and an input clock selection signal SLC1 for switching the inverted signal to the input clock source signal CLK1. When the operation for switching to the input clock source signal CLK2 is executed in a state where the input clock source signal CLK1 has been selected, the input clock selection signal SLC1 drops from "H" (high) level to "L" (low). For this reason, the "L" level signal is outputted from the AND circuit 54 after the operation for clock switching regardless of the level of the input clock source signal CLK1.

Inputted into the AND circuit 55 are an inverted signal of an input clock source signal CLK2 and an input clock selection signal SLC2 for switching the inverted signal to the input clock source signal CLK2. Herein, as the input clock selection signal SLC2 changes at a timing different from that of the input clock selection signal SLC1, the input clock selection signal SLC2 remains at "L" level for the period of time gap. For this reason, output of the "L" level signal from the AND circuit 55 to the NOR circuit 57 is maintained.

Inputted into the AND circuit 56 are an inverted signal of an input clock source signal CLK3 and an input clock selection signal SLC3 for switching the inverted signal to the input clock source signal CLK3. The input clock source signal CLK3 does not effect for switching clocks at this time and no change occurs in the input clock selection signal SLC3, so that output of the "L" level signal from the AND circuit 56 to the NOR circuit 57 is maintained.

Referring to the operations in the NOR circuit 57 before start of the operation for switching clocks, since signals at "L" level are always outputted from the AND circuits 55 and 56, a change in output from the NOR circuit 57 depends on a change in the input clock source signal CLK1 currently being used. For this reason, if the operation for clock switching is executed when the input clock source signal CLK1 is at "L" level, a "L" level signal is outputted from the AND circuit 54 at the timing of switching, and the input clock source signal CLK is changed to "H" level at the above timing in the NOR circuit 57.

Then, if the input clock selection signal SLC2 is changed to "H" level when the input clock source signal CLK1 is at of "L" level, a "H" level signal is outputted from the AND circuit 55 to the NOR circuit 57. For this reason, in the NOR circuit 57, the clock source signal CLK having changed to "H" level at a timing of changing in the input clock selection signal SLC1 is changed to "L" level at a timing of changing in the input clock selection signal SLC2. As a result, the operation for clock switching is finished and a clock signal CLK according to the input clock source signal CLK2 is supplied from the NOR circuit 57 to the system.

In the clock switching apparatus based on the conventional technology, however, as shown in Fig. 9, the input clock selection signals SLC1 and SLC2 change asynchronously to the input clock source signals CLK1 and CLK2 to be switched, so that the timing when the input clock selection signals SLC1 and SLC2 change does not match to the timing when the input clock source signals CLK1 and CLK2 to be switched change. Because of this time gap, a pulse P2 indicated by a solid line is generated at a place where a pulse P1 indicated by a dotted line should be formed. Accordingly, a time interval between the pulse P2 and the adjacent pulse is narrower than the normal interval, which causes a pulse width to become narrower, and for this reason malfunction may occur in the system in which the clock switching operation is executed depending on the clock switching apparatus, or system down may be caused thereby.

It is desirable to provide a clock switching apparatus which can realize stable clock switching by preventing abnormalities in clocks such as a split waveform of a clock and a narrowed clock pulse width at the time of clock switching.

A clock switching apparatus according to the present invention for switching clocks between a plurality of input clock source signals asynchronous to each other and each having a different phase comprises a circuit for generating a reference clock signal from input clock source signals before and after switching of the plurality of input clock source signals according to an clock switching operation, synchronizing to the generated reference clock signal, and switching a clock from the input clock source signal before switching to the input clock source signal after the switching according to a timing of the clock switching operation.

With the clock switching apparatus according to the present invention, a reference clock signal is generated from input clock source signals before and after switching according to an clock switching operation, and the switching of clocks is synchronized to the reference clock signal and controlled according to a timing of the clock switching operation, so that the input clock source signal to be switched is synchronized to the timing for clock switching, and with this operation, the stable clock switching can be realized without any abnormality in clocks.

A clock switching apparatus embodying the present invention for switching clocks according to a plurality of input clock selection signals correlated one versus one to a plurality of input clock source signals asynchronous to each other and each having a different phase respectively comprises a switching detector for detecting a change among the plurality of input clock selection signals according to a clock selecting operation, a switching/holding circuit for holding a switching order among the plurality of input clock source signals according to the plurality of input clock selection signals and the change detected by the switching detector, a reference clock generator for generating a reference clock signal according to input clock source signals before and after switching of the plurality of input clock source signals according to the switching order held by the switching/holding circuit, a synchronizing circuit for synchronizing the change detected by the switch detector to the reference clock signal generated by the reference clock generator and generating a clock selection signal in synchronism with the input clock source signal after the switching, and a clock switching circuit for switching clocks from the input clock source signal before the switching to that after the switching according to the clock selection signal generated by the synchronizing circuit.

With the clock switching apparatus embodying the present invention, a switching order of clocks is held according to change in input clock selection signals, a reference clock signal is generated according to input clock source signals before and after switching based on the switching order, a clock selection signal is generated in synchronism with the reference clock signal, and clock switching is executed at a timing of generating the clock selection signal, so that an input clock source signal to be switched and a clock selection signal finally generated for switching clocks are synchronized to an input clock selection signal, and with this operation, the stable clock switching can be realized without any abnormality in clocks.

A clock switching apparatus embodying the present invention is characterized in that, the switching/holding circuit holds, of the plurality of input clock selection signals, an input clock selection signal before switching and an input clock selection signal after the switching as a switching order.

With the clock switching apparatus embodying the present invention, a switching order of clocks is held by using input clock selection signals, so that input clock source signals before and after the switching each in synchronism with a clock selection signal can securely be insured.

A clock switching apparatus embodying the invention is characterized in that, the switching/holding circuit has a flip-flop for holding an input clock selection signal before switching and an input clock selection signal after the switching.

With the clock switching apparatus embodying the present invention, an input clock selection signal before switching and an input clock selection signal after the switching is held by a flip-flop, so that a switching order at the current point can be maintained until the switching order is changed.

A clock switching apparatus embodying the present invention is characterized in that, the reference clock generator always generates one or a plurality of reference clock signals according to the plurality of input clock source signals, and selects any reference clock signal of the one or plurality of reference clock signals according to the switching order held by the switching/holding circuit.

With the clock switching apparatus embodying the present invention, a reference clock signal is generated from a plurality of input clock source signals regardless of whether clocks are switched or not, so that a clock selection signal is prepared with some time allowance in response to change of the switching order, and with this feature, the stable clock switching can be realized without delay at any time when clocks are changed.

A clock switching apparatus embodying the present invention is characterized in that, the reference clock generator computes a logical sum for every two input clock source signals among the plurality of input clock source signals to generate the one or plurality of reference clock signals.

With the clock switching apparatus embodying the present invention, a reference clock signal is obtained by means of a logical sum between input clock source signals, so that a clock width can be controlled so as to be made wider, and with this operation, the stability on operations can be insured.

A clock switching apparatus embodying the present invention is characterized in that, the reference clock generator comprises an OR circuit for operating a logical sum between each two input clock source signals.

With the clock switching apparatus embodying the present invention, an AND operation can be executed to every two input clock source signals by applying an OR circuit in the reference clock generator.

A clock switching apparatus embodying the present invention is characterized in that, the switching detector comprises a chopper circuit for forming a pulse waveform according to a change in the plurality of input clock selection signals.

With the clock switching apparatus embodying the present invention, a change in the plurality of input clock selection signals can be fetched as a pulse waveform by applying the chopper circuit.

Reference is made, by way of example, to the accompanying drawings in which:-

Fig. 1 is a block diagram of circuits showing internal configuration of a clock switching apparatus according to one embodiment of the present invention;

Fig. 2 is a timing chart showing an example of operations in the circuits shown in Fig. 1;

Fig. 3 is a timing chart showing an example of operations in the circuits shown in Fig. 1;

Fig. 4 is a timing chart showing an example of operations in the circuits shown in Fig. 1;

Fig. 5 is a timing chart showing an example of operations in the circuits shown in Fig. 1;

Fig. 6 is a timing chart showing an example of operations in the circuits shown in Fig. 1;

Fig. 7 is a timing chart showing an example of operations in the circuits shown in Fig. 1;

Fig. 8 is a block diagram of circuits showing internal configuration of a clock switching apparatus based on the conventional technology; and

Fig. 9 is a timing chart showing an example of operations in the circuits shown in Fig. 8.

Detailed description is made hereinafter for preferred embodiments of a clock switching apparatus according to the present invention with reference to the accompanying drawings.

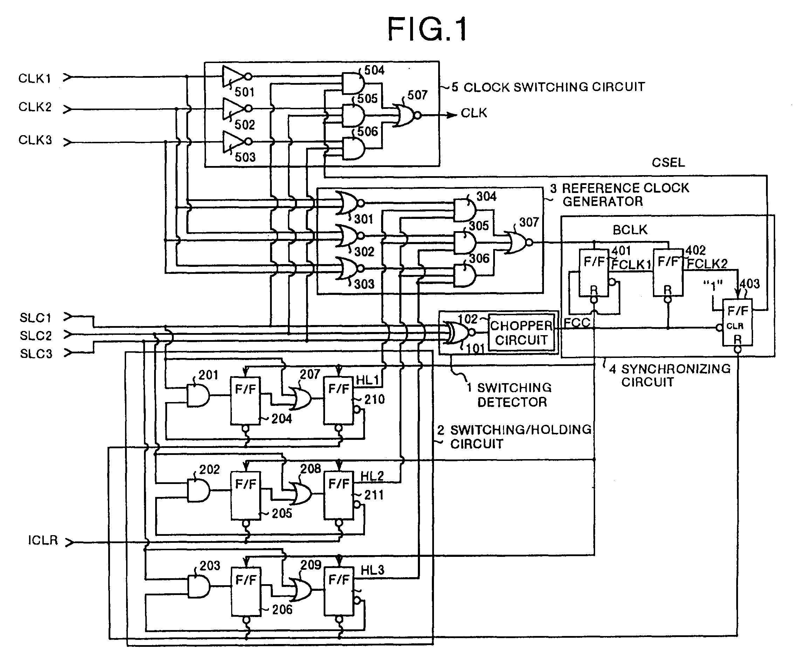

First, description is made for the configuration thereof. Fig. 1 is a block diagram of circuits showing internal configuration of a clock switching apparatus according to one embodiment of the present invention. Fig. 1 shows a clock switching apparatus, in order to enable comparison of the apparatus to the clock switching apparatus based on the conventional technology shown in Fig. 8, for switching clocks according to three types of input clock selection signals SLC1 to SLC3 correlated one versus one to three types of input clock source signals CLK1 to CLK3 asynchronous to each other and each having a different phase.

The clock switching apparatus according to this embodiment comprises, as shown in Fig. 1, a switching detector 1, a switching/holding circuit 2, a reference clock generator 3, a synchronizing circuit 4, and a clock switching circuit 5.

The switching detector 1 comprises an ENOR circuit 101 and a chopper circuit 102, receives input clock selection signals SLC1 to SLC3, and detects a change in signals by an operation for switching clocks as a pulse. The ENOR circuit 101 operates exclusive-OR among the input clock selection signals SLC1 to SLC3, and the chopper circuit 102 fetches a pulse waveform from an output signal according to the operated exclusive-OR and outputs the pulse as reset signals for flip-flops 401, 402 and as a clear signal for a flip-flop 403 (both type of signals are referred to as a clear clock signal FCC) in the synchronizing circuit 4. Those ENOR circuit 101 and chopper circuit 102 form, if there occurs a change in any of the input clock selection signals SLC1 to SLC3, a pulse, namely a clear clock signal FCC according to the input clock selection signal in which the change has occurred.

The switching/holding circuit 2 comprises three systems of holding circuits correlating to the three input clock selection signals SLC1 to SLC3 respectively. Namely, there are an AND circuit 201, a flip-flop (indicated by F/F in the figure) 204, an OR circuit 207, and a flip-flop 210 serially connected to each other correlated to the input clock selection signal SLC1. There are an AND circuit 202, a flip-flop 205, an OR circuit 208, and a flip-flop 211 serially connected to each other correlated to the input clock selection signal SLC2. Also, there are an AND circuit 203, a flip-flop 206, an OR circuit 209, and a flip-flop 212 serially connected to each other correlated to the input clock selection signal SLC3.

Provided in each of the three systems of holding circuit in this switching/holding circuit 2 are the flip-flops in two stages, and input clock selection signals received before and after switching clocks can be held therein by this two-stage configuration. Flip-flops 210, 211, 212 output the held clock selection signals SLC1, SLC2, SLC3 to the reference clock generator 3 as hold signals HL1 to HL3 respectively. Also, the flip-flops 204 to 212 are initialized by receiving an initial clear signal ICLR.

The reference clock generator 3 generates a reference clock signal BCLK for switching clocks according to two input clock source signals before and after switching clocks of the three types of input clock source signals CLK1 to CLK3. This reference clock generator 3 comprises NOR circuits 301 to 303 each for operating a NOR between each two signals of the three types of input clock source signals CLK1 to CLK3, AND circuits 304 to 306 each for operating a logical product between an output signal from each of the NOR circuits 301 to 303 correlating thereto and the correlating input clock selection signal (from the switching/holding circuit 2), and an NOR circuit 307 for obtaining a reference clock signal BCLK by operating a NOR between output signals from the AND circuits 304 to 306.

This reference clock generator 3 always generates a reference clock signal comprising two signals of the input clock source signals CLK1 to CLK3 by the NOR circuits 301 to 303, and outputs an input reference clock signal from the NOR circuit 307 as a reference clock signal BCLK only through the AND circuits each receiving an input clock selection signal outputted from the switching/holding circuit 2.

The synchronizing circuit 4 synchronizes a received signal to a reference clock signal BCLK supplied from the reference clock generator 3 after being initialized by an output pulse (signal FCC) from the switching detector 1 in synchronism with the change in the input clock selection signals SLC1 to SLC3, and outputs the signal to the clock switching circuit 5 as a final clock selection signal CSEL.

This synchronizing circuit 4 has flip-flops 401 to 403 and a reference clock signal BCLK is synchronized to an input clock selection signal in which a change occurs in response to movement of those flip-flops 401 to 403. The flip-flop 401 outputs an output clock signal FCLK1 to the flip-flop 402 provided in the latter stage, the flip-flop 402 outputs an output clock signal FCLK2 to the flip-flop 403 provided in the latter stage, and the flip-flop 403 simultaneously outputs the clock selection signal CSEL as an output clock to AND circuits 504 to 506 for the clock switching circuit 5.

The clock switching circuit 5 comprises inverters 501 to 503 for inverting and outputting input clock source signals CLK1 to CLK3 respectively, AND circuits 504 to 506 each for operating a logical product among an output signal from each of the inverters 501 to 503 correlating to each of the input clock source signals CLK1 to CLK3, each of input clock selection signals SLC1 to SLC3 and a clock selection signal CSEL supplied from the synchronizing circuit 4, and a NOR circuit 507 for operating a NOR of output signals from the AND circuits 504 to 506 and outputting a clock signal CLK for system supply.

Simultaneously inputted in the AND circuits 504 to 506 in this clock switching circuit 5 is a clock selection signal CSEL supplied from the synchronizing circuit 4. For this reason, the clock switching is not executed at a timing when any clock selection signals SLC1 to SLC3 change in asynchronism with an input clock source signal to be switched as is in the conventional technology, but is executed according to the change in any of the input clock selection signals SLC1 to SLC3 at the timing when a clock selection signal CSEL in synchronism with an input clock source signal to be switched is received.

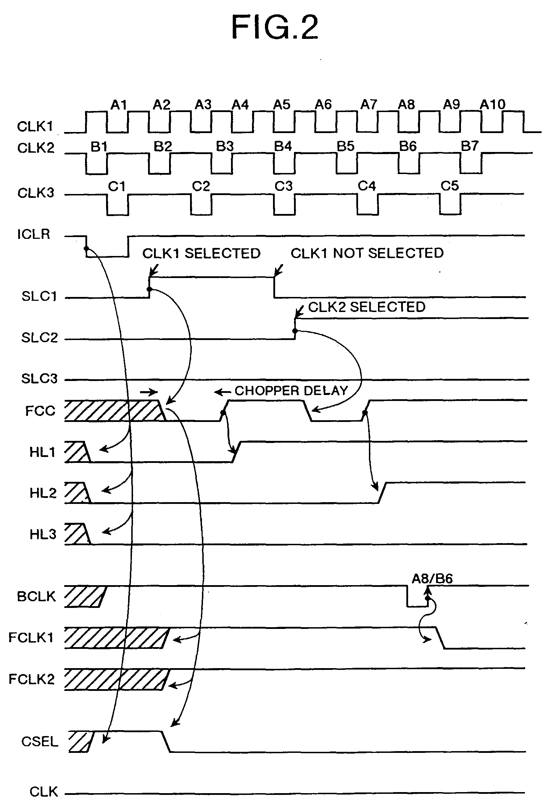

Next description is made for operations based on the circuit configuration described above. Fig. 2 to Fig. 7 are timing charts each showing an example of operations of the circuit shown in Fig. 1. Fig. 2 to Fig. 7 show waveforms of input clock source signals CLK1 to CLK3, an initial clear signal ICLR, input clock selection signals SLC1 to SLC3, a clear clock signal FCC, hold signals HL1 to HL3, a reference clock signal BCLK, output clock signals FCLK1 and FCLK2, a clock selection signal CSEL, and a clock signal CLK, respectively.

The input clock source signals CLK1 to CLK3 are asynchronous to each other and each has a different phase for each other. In the examples shown in Fig. 2 to Fig. 7, the input clock source signals CLK1, CLK2, CLK3 are indicated by pulses with the reference numerals A1 to A76, B1 to B51, and C1 to C38, respectively.

Also, the input clock selection signals SLC1 to SLC3 are given by being correlated one versus one to the input clock source signals CLK1 to CLK3. In the examples shown in Fig. 2 to Fig. 7, at first, the input clock selection signal SLC1 is selected as the default at the time of initialization, so that the input clock source signal CLK1 is selected as a clock signal CLK for the default.

As an initial operation, all the flip-flops 204 to 206 and 210 to 212 are cleared in the switching/holding circuit 2 when the initial clear signal ICLR is changed to "L" level, and at the same time the flip-flop 403 is reset in the synchronizing circuit 4. For this reason, as the hold signals HL1 to HL3 as each output from the flip-flops 210 to 212 are changed from "H" level to "L" level, a reference clock signal BCLK as an output from the reference clock generator 3 is changed to "H" level.

Also, by having reset the flip-flop 403, a clock selection signal CSEL as an output therefrom is changed to a "H" level signal according to an input of "1". It should be noted that each of shaded portions in the "L" period shows the default in Fig. 2.

A dummy clock is used as first selection of a clock in the circuit shown in Fig. 1. The input clock source signal CLK1 is used as the dummy clock in this embodiment. The input clock selection signal SLC1 is changed to "H" level by a dummy instruction for selection of the input clock source signal CLK1. The change of this input clock selection signal SLC1 is made to a pulse by a chopper delay, and the pulse is outputted to the flip-flops 401 to 403 as a clear clock signal FCC.

This clear clock signal FCC is also outputted to each of the flip-flops 204 to 206 and 210 to 212 in the switching/holding circuit 2. At this point of time, as the input clock selection signal SLC1 has been selected, the hold signal HL1 is changed from "L" level to "H" level at a rising timing of a pulse of the input clear clock signal FCC in the flip-flop 210.

Of the hold signals HL1 to HL3, only one signal forms the "H" period in this step, and for this reason any of the AND circuits 304 to 306 in the reference clock generator 3 outputs a "L" level signal. In this case, the reference clock signal BCLK is held at "H" level.

Accordingly, the flip-flop 403 in the synchronizing circuit 4 holds the clock selection signal CSEL at "L" level. As all outputs from the AND circuits 504 to 506 in the clock switching circuit 5 are changed to "L" level in this state, none of input clock source signals CLK1 to CLK3 is outputted, and the clock signal CLK remains to be held at "H" level.

Output clock signals FCLK1 and FCLK2 which are output signals are changed to "H" level in response to receiving of a clear clock signal FCC in the flip-flops 401 and 402 for the synchronizing circuit 4. In the flip-flop 403, on the other hand, the clock selection signal CSEL as an output therefrom is changed to "L" level because the "H" period has already been formed.

Herein, as conditions required for clock switching do not hold only with generation of one clock selection signal, and to break this state, it is required to further generate an input clock selection signal SLC2 as a dummy and give artificially input clock source signals before and after the switching.

Then, when the input clock selection signal SLC1 is changed to "L" level and the input clock selection signal SLC2 is changed from "L" level to "H" level in the system, a pulse of the clear clock signal FCC due to a chopper delay is again formed in the switching detector 1. At this time, the hold signal HL2 is changed from "L" level to "H" level at the rising of the pulse of the clear clock signal FCC, and the "H" period of the hold signal HL2 is started.

Both of the hold signal HL1 correlating to the input clock selection signal SLC1 and the hold signal HL2 correlating to the input clock selection signal SLC2 are at the "H" period at this point of time. With this feature, an output from the AND circuit 304 is changed to "H" level in the reference clock generator 3, and for this reason one pulse at "L" level is formed on the reference clock signal BCLK. This one pulse is a signal formed by a logical sum (actually an exclusive-OR) between the input clock source signals CLK1 (pulse A8) and CLK2 (pulse B6).

The next pulse on the reference clock signal BCLK is formed by a logical sum (actually an exclusive-OR) between a pulse A11 of the input clock source signal CLK1 and a pulse B8 of the input clock source signal CLK2. A cycle (pulse interval) of the reference clock signal BCLK obtained as described above is acquired by operating a logical sum between the input clock source signals CLK1 and CLK2 inputted in the NOR circuit 301.

For this reason, the input clock source signals CLK1 and CLK2 have a combinational relation in which pulses B10, B12 · · · · are correlated to pulses A14, A17 · · · thereafter and on in the same manner as described above. Pulses of the reference clock signal BCLK are successively formed at a prespecified cycle according to this combinational relation.

In the flip-flop 401 for the synchronizing circuit 4, an output clock signal FCLK1 is changed from "H" level to "L" level in response to an input of the first reference clock signal BCLK (a combination of the pulses A8 and B6), and the output clock signal FCLK1 is changed from "L" level to "H" level in response to an input of the following reference clock signal BCLK (a combination of the pulses A11 and B8). Thereafter and on, changes between "L" and "H" are repeated according to input of the reference clock signal BCLK in the same manner as described above.

In contrast, in the flip-flop 402, changes between "L" and "H" are repeated according to input of the reference clock signal BCLK after an one-cycle delay from that in the flip-flop 401. For this reason, the output clock signal FCLK2 from the flip-flop 402 forms a waveform in a reverse direction to that of the output clock signal FCLK1 from the flip-flop 401.

Further, the output clock signal FCLK2 from the flip-flop 402 is inputted in the flip-flop 403 after a two-cycle delay from that in the flip-flop 401 and after an one-cycle delay from that in the flip-flop 402 described above, and at the input timing, the "1", namely "H" level signal is outputted to the clock switching circuit 5 as a clock selection signal CSEL. Thereafter and on, this flip-flop 403 holds the clock selection signal CSEL in the "H" period until a clear clock signal FCC is received from the switching detector 1.

Although this clock selection signal CSEL (at "H" level) is simultaneously inputted in the AND circuits 504 to 506 for the clock switching circuit 5, only the AND circuit 505 for receiving an input clock selection signal SLC2 passes therethrough the input clock source signal CLK2 correlating to the circuit because the AND operation is executed. With this operation, the NOR circuit 507 supplies a clock signal CLK as the input clock source signal CLK2 to the system.

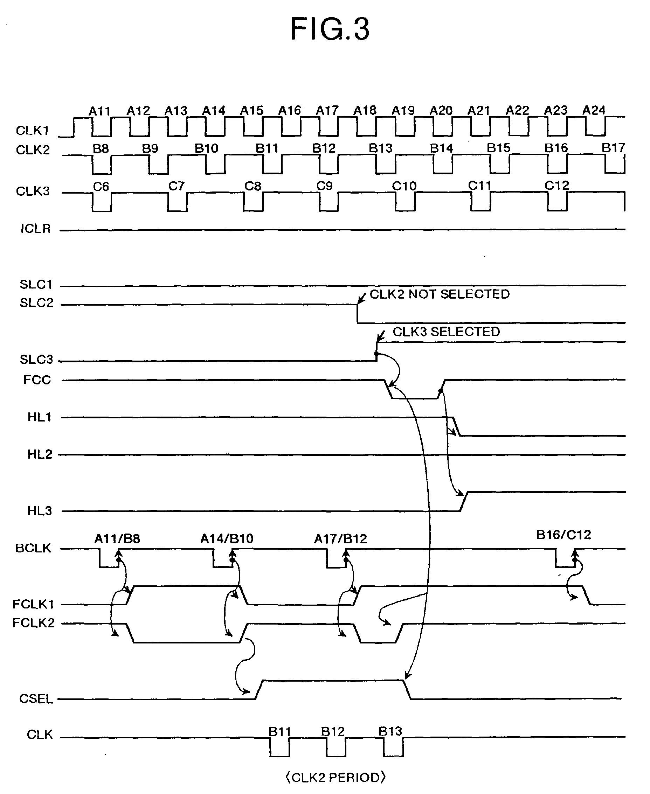

Starting of this clock signal CLK is effected after the clock selection signal CSEL rises, and from the pulse B11 of the input clock source signal CLK2 in the example in Fig. 3. The preprocessing for starting a clock supply is finished as described above. Thereafter and on, the operation for clock switching is executed according to an input clock selection signal generated in response to a request from the system.

Then, as shown in Fig. 3, when the operation for switching to an input clock source signal CLK3 is executed after a pulse B12 of the input clock source signal CLK2, the operation is not a pseudo operation, but the normal clock switching is started.

At this point of time, the input clock selection signal SLC2 is changed from "H" level to "L" level because it has not been selected, while the input clock selection signal SLC3 is changed from "L" level to "H" level because it has been selected. When changes in the input clock selection signals SLC2 and SLC3 are detected by the switching detector 1, a chopper delay is formed on the clear clock signal FCC according to the change to "H" level of the input clock selection signal SLC3.

The change of this clear clock signal FCC to "L" level makes the clock selection signal CSEL outputted from the flip-flop 403 in the synchronizing circuit 4 changed to "L" level to clear the flip-flop. Namely, the flip-flop 403 functions to stop selection of an input clock source signal CLK2 at a generating timing of the clear clock signal FCC. In accordance with the stopping of selection, in the clock switching circuit 5, the input clock source signal CLK2 from the AND circuit 505 can not pass, and the clock signal CLK is held in the original "H" period.

Then, the chopper delay period of the clear clock signal FCC is finished. The hold signal HL1 from the flip-flop 210 is changed to "L" level at the finishing timing, and this time, the hold signal HL3 from the flip-flop 212 is changed to "H" level. With this feature, the input clock selection signals SLC2 and SLC3 before and after the clock switching, namely both the hold signals HL2 and HL3 are held in the "H" period.

In accordance with the above operation, a logical sum (actually a NOR) between the input clock source signals CLK2 and CLK3 each inputted in the AND circuit 306 for the reference clock generator 3 is outputted to the NOR circuit 307 this time. For this reason, a reference clock signal BCLK comprising the input clock source signals CLK2 and CLK3 is supplied to the synchronizing circuit 4. The first reference clock signal BCLK is formed, as shown in Fig. 3, by a pulse B16 of the input clock source signal CLK2 as well as by a pulse C12 of the input clock source signal CLK3.

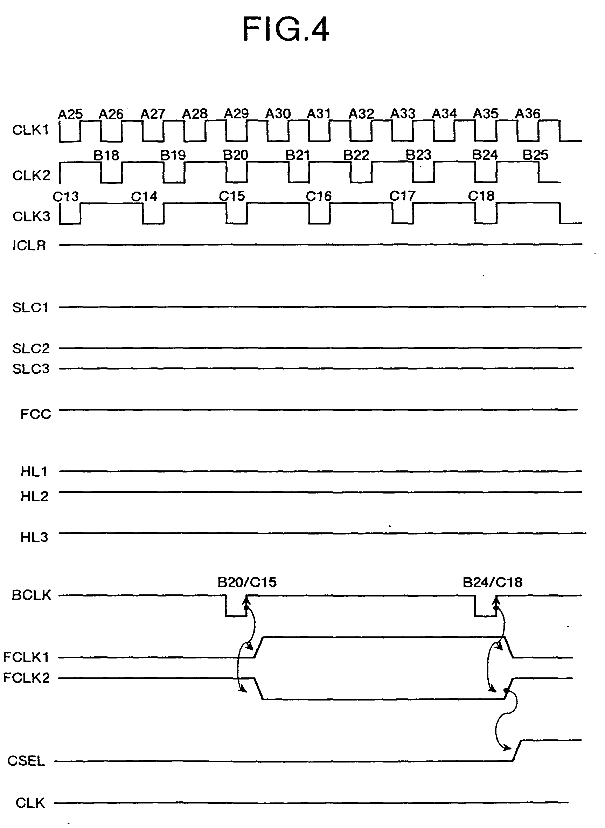

The next pulse of the reference clock signal BCLK is formed, as shown in Fig. 4, by a logical sum (actually a NOR) between a pulse B20 of the input clock source signal CLK2 and a pulse C15 of the input clock source signal CLK3. A cycle (pulse interval) of the reference clock signal BCLK obtained as described above is acquired by operating a logical sum between the input clock source signals CLK2 and CLK3 inputted in the NOR circuit 303.

For this reason, the input clock source signals CLK2 and CLK3 have a combinational relation in which pulses C18, C21 · · · are correlated to pulses B24, B28 · · · thereafter and on in the same manner as described above. Pulses of the reference clock signal BCLK are successively formed at a prespecified cycle according to this combinational relation.

In the flip-flop 401 for the synchronizing circuit 4, an output clock signal FCLK1 is changed from "H" level to "L" level in response to an input of the first reference clock signal BCLK (a combination of the pulses B16 and C12), and the output clock signal FCLK1 is changed from "L" level to "H" level in response to an input of the following reference clock signal BCLK (a combination of the pulses B20 and C15). Thereafter and on, changes between "L" and "H" are repeated according to input of the reference clock signal BCLK in the same manner as described above.

In contrast, in the flip-flop 402, changes between "L" and "H" are repeated according to input of the reference clock signal BCLK after an one-cycle delay from that in the flip-flop 401. For this reason, the output clock signal FCLK2 from the flip-flop 402 forms a waveform in a reverse direction to that of the output clock signal FCLK1 from the flip-flop 401.

Further, the output clock signal FCLK2 from the flip-flop 402 is inputted in the flip-flop 403 after a two-cycle delay from that in the flip-flop 401 and after an one-cycle delay from that in the flip-flop 402 described above, and at the input timing, the "1", namely "H" level signal is outputted to the clock switching circuit 5 as a clock selection signal CSEL. Thereafter and on, this flip-flop 403 holds the clock selection signal CSEL in the "H" period until a clear clock signal FCC is received from the switching detector 1.

Although this clock selection signal CSEL (at "H" level) is simultaneously inputted in the AND circuits 504 to 506 for the clock switching circuit 5, only the AND circuit 506 for receiving an input clock selection signal SLC3 passes therethrough the input clock source signal CLK3 correlating to the circuit because the AND operation is executed. With this operation, the NOR circuit 507 supplies a clock signal CLK as the input clock source signal CLK3 to the system.

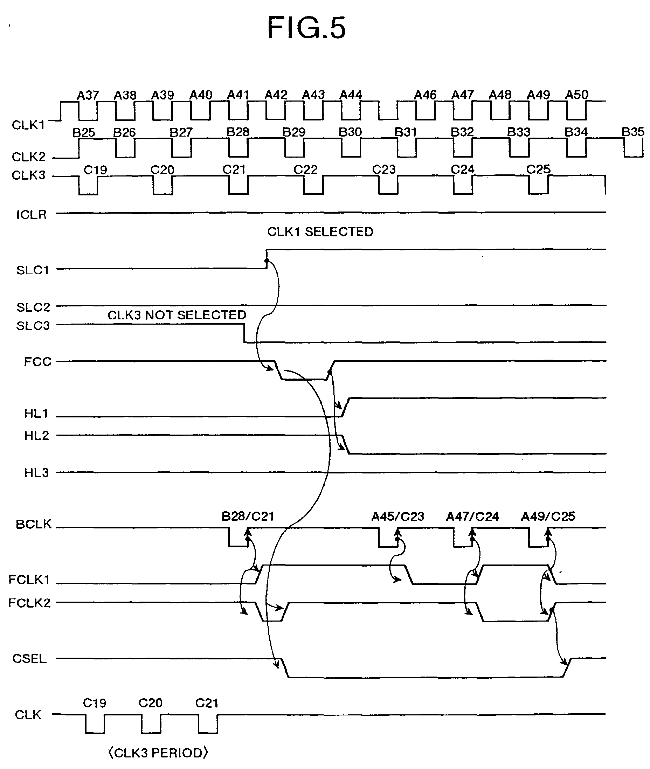

Starting of this clock signal CLK is effected after the clock selection signal CSEL rises, and from the pulse C19 of the input clock source signal CLK3 in the example in Fig. 5. The operation for clock switching is executed as described above according to the input clock selection signal SLC3 generated in response to a request from the system.

Then, as shown in Fig. 5, when the operation for switching to the input clock source signal CLK1 is executed at the time of a pulse C21 of the input clock source signal CLK3, the operation for clock switching from the input clock source signal CLK3 to the input clock source signal CLK1 is started. At this point of time, the input clock selection signal SLC3 is changed from "H" level to "L" level because it has not been selected, while the input clock selection signal SLC1 is changed from "L" level to "H" level because it has been selected. When changes in the input clock selection signals SLC3 and SLC1 are detected by the switching detector 1, a chopper delay is formed on the clear clock signal FCC according to the change to "H" level of the input clock selection signal SLC1.

The change of this clear clock signal FCC to "L" level makes the clock selection signal CSEL outputted from the flip-flop 403 in the synchronizing circuit 4 changed to "L" level to clear the signal. Namely, the flip-flop 403 functions to stop selection of the input clock source signal CLK3 at a generating timing of the clear clock signal FCC. In accordance with the stopping of selection, in the clock switching circuit 5, the input clock source signal CLK3 from the AND circuit 506 can not pass, and the clock signal CLK is held in the original "H" period.

Then, the chopper delay period of the clear clock signal FCC is finished. The hold signal HL2 from the flip-flop 211 is changed to "L" level at the finishing timing, and this time, the hold signal HL1 from the flip-flop 210 is changed to "H" level. With this feature, the input clock selection signals SLC3 and SLC1 before and after the clock switching, namely both the hold signals HL3 and HL1 are held in the "H" period.

In accordance with the above operation, a logical sum (actually a NOR) between the input clock source signals CLK1 and CLK3 each inputted in the AND circuit 305 for the reference clock generator 3 is outputted to the NOR circuit 307 this time. For this reason, a reference clock signal BCLK comprising the input clock source signals CLK1 and CLK3 is supplied to the synchronizing circuit 4. The first reference clock signal BCLK is formed, as shown in Fig. 5, with a pulse A45 of the input clock source signal CLK1 as well as with a pulse C23 of the input clock source signal CLK3.

The next pulse of the reference clock signal BCLK is formed, as shown in Fig. 5, by a logical sum (actually a NOR) between a pulse A47 of the input clock source signal CLK1 and a pulse C24 of the input clock source signal CLK3. A cycle (pulse interval) of the reference clock signal BCLK obtained as described above is acquired by operating a logical sum between the input clock source signals CLK1 and CLK3 inputted in the NOR circuit 302.

For this reason, the input clock source signals CLK1 and CLK3 have a combinational relation in which pulses C25, C26, C27 · · · are correlated to pulses A49, A51, A53 · · · thereafter and on in the same manner as described above. Pulses of the reference clock signal BCLK are successively formed at a prespecified cycle according to this combinational relation.

In the flip-flop 401 for the synchronizing circuit 4, an output clock signal FCLK1 is changed from "H" level to "L" level in response to an input of the first reference clock signal BCLK (a combination of the pulses A45 and C23), and the output clock signal FCLK1 is changed from "L" level to "H" level in response to an input of the following reference clock signal BCLK (a combination of the pulses A47 and C24). Thereafter and on, changes between "L" and "H" are repeated according to input of the reference clock signal BCLK in the same manner as described above.

In contrast, in the flip-flop 402, changes between "L" and "H" are repeated according to input of the reference clock signal BCLK after a one-cycle delay from that in the flip-flop 401. For this reason, the output clock signal FCLK2 from the flip-flop 402 forms a waveform in a reverse direction to that of the output clock signal FCLK1 from the flip-flop 401.

Further, the output clock signal FCLK2 from the flip-flop 402 is inputted in the flip-flop 403 after a two-cycle delay from that in the flip-flop 401 and after an one-cycle delay from that in the flip-flop 402 described above, and at the input timing, the "1", namely "H" level signal is outputted to the clock switching circuit 5 as a clock selection signal CSEL. Thereafter and on, this flip-flop 403 holds the clock selection signal CSEL in the "H" period until a clear clock signal FCC is received from the switching detector 1.

Although this clock selection signal CSEL (at "H" level) is simultaneously inputted in the AND circuits 504 to 506 for the clock switching circuit 5, only the AND circuit 504 for receiving an input clock selection signal SLC1 passes therethrough the input clock source signal CLK1 correlating to the circuit because the AND operation is executed. With this operation, the NOR circuit 507 supplies a clock signal CLK as the input clock source signal CLK1 to the system.

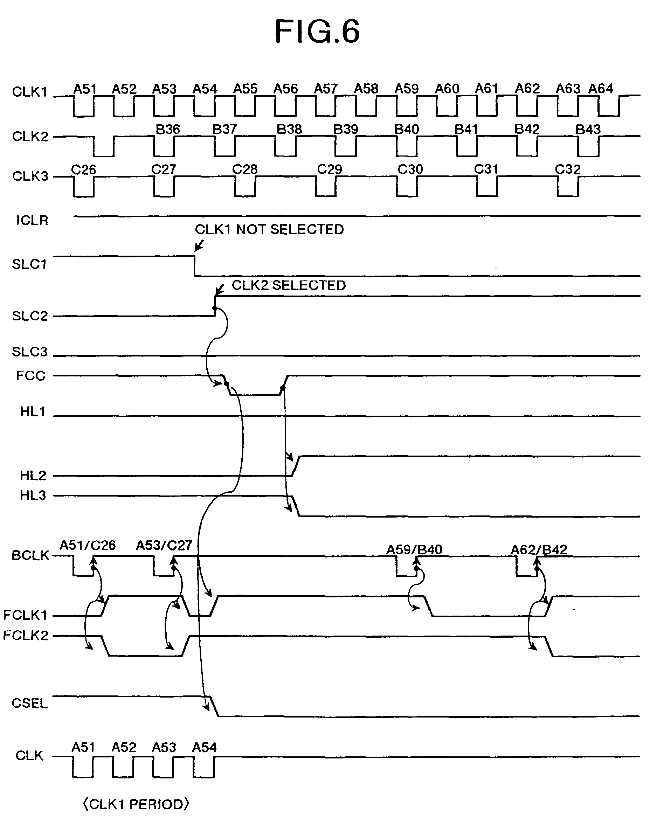

Starting of this clock signal CLK is effected after the clock selection signal CSEL rises, and from the pulse A51 of the input clock source signal CLK1 in the example in Fig. 6. The operation for clock switching is executed as described above according to the input clock selection signal SLC3 generated in response to a request from the system.

Then, as shown in Fig. 6, when the operation for switching to the input clock source signal CLK2 is executed at the time of a pulse A54 of the input clock source signal CLK1, the operation for clock switching from the input clock source signal CLK1 to the input clock source signal CLK2 is started.

At this point of time, the input clock selection signal SLC1 is changed from "H" level to "L" level because it has not been selected, while the input clock selection signal SLC2 is changed from "L" level to "H" level because it has been selected. When changes in the input clock selection signals SLC1 and SLC2 are detected by the switching detector 1, a chopper delay is formed on the clear clock signal FCC according to the change to "H" level of the input clock selection signal SLC2.

The change of this clear clock signal FCC to "L" level makes the clock selection signal CSEL outputted from the flip-flop 403 in the synchronizing circuit 4 changed to "L" level to clear the signal. Namely, the flip-flop 403 functions to stop selection of the input clock source signal CLK1 at a generating timing of the clear clock signal FCC. In accordance with the stopping of selection, in the clock switching circuit 5, the input clock source signal CLK1 from the AND circuit 504 can not pass, and the clock signal CLK is held in the original "H" period.

Then, the chopper delay period of the clear clock signal FCC is finished. The hold signal HL3 from the flip-flop 212 is changed to "L" level at the finishing timing, and this time, the hold signal HL2 from the flip-flop 211 is changed to "H" level. With this feature, the input clock selection signals SLC1 and SLC2 before and after the clock switching, namely both the hold signals HL1 and HL2 are held in the "H" period.

In accordance with the above operation, a logical sum (actually a NOR) between the input clock source signals CLK1 and CLK2 each inputted in the AND circuit 304 for the reference clock generator 3 is outputted to the NOR circuit 307 this time. For this reason, a reference clock signal BCLK comprising the input clock source signals CLK1 and CLK2 is supplied to the synchronizing circuit 4. The first reference clock signal BCLK is formed, as shown in Fig. 6, with a pulse A59 of the input clock source signal CLK1 as well as with a pulse B40 of the input clock source signal CLK2.

The next pulse of the reference clock signal BCLK is formed, as shown in Fig. 6, by a logical sum (actually a NOR) between a pulse A62 of the input clock source signal CLK1 and a pulse B42 of the input clock source signal CLK2. A cycle (pulse interval) of the reference clock signal BCLK obtained as described above is acquired by operating a logical sum between the input clock source signals CLK1 and CLK2 inputted in the NOR circuit 301.

For this reason, the input clock source signals CLK1 and CLK2 have a combinational relation in which pulses B44, B46, B48, B50 ··· are correlated to pulses A65, A68, A71, A74 ··· thereafter and on in the same manner as described above. Pulses of the reference clock signal BCLK are successively formed at a prespecified cycle according to this combinational relation.

In the flip-flop 401 for the synchronizing circuit 4, an output clock signal FCLK1 is changed from "H" level to "L" level in response to an input of the first reference clock signal BCLK (a combination of the pulses A59 and B40), and the output clock signal FCLK1 is changed from "L" level to "H" level in response to an input of the following reference clock signal BCLK (a combination of the pulses A62 and B42). Thereafter and on, changes between "L" and "H" are repeated according to input of the reference clock signal BCLK in the same manner as described above.

In contrast, in the flip-flop 402, changes between "L" and "H" are repeated according to input of the reference clock signal BCLK after a one-cycle delay from that in the flip-flop 401. For this reason, the output clock signal FCLK2 from the flip-flop 402 forms a waveform in a reverse direction to that of the output clock signal FCLK1 from the flip-flop 401.

Further, the output clock signal FCLK2 from the flip-flop 402 is inputted in the flip-flop 403 after a two-cycle delay from that in the flip-flop 401 and after an one-cycle delay from that in the flip-flop 402 described above, and at the input timing, the "1", namely "H" level signal is outputted to the clock switching circuit 5 as a clock selection signal CSEL. Thereafter and on, this flip-flop 403 holds the clock selection signal CSEL in the "H" period until a clear clock signal FCC is received from the switching detector 1.

Although this clock selection signal CSEL (at "H" level) is simultaneously inputted in the AND circuits 504 to 506 for the clock switching circuit 5, only the AND circuit 505 for receiving an input clock selection signal SLC2 passes therethrough the input clock source signal CLK2 correlating to the circuit because the AND operation is executed. With this operation, the NOR circuit 507 supplies a clock signal CLK as the input clock source signal CLK2 to the system.

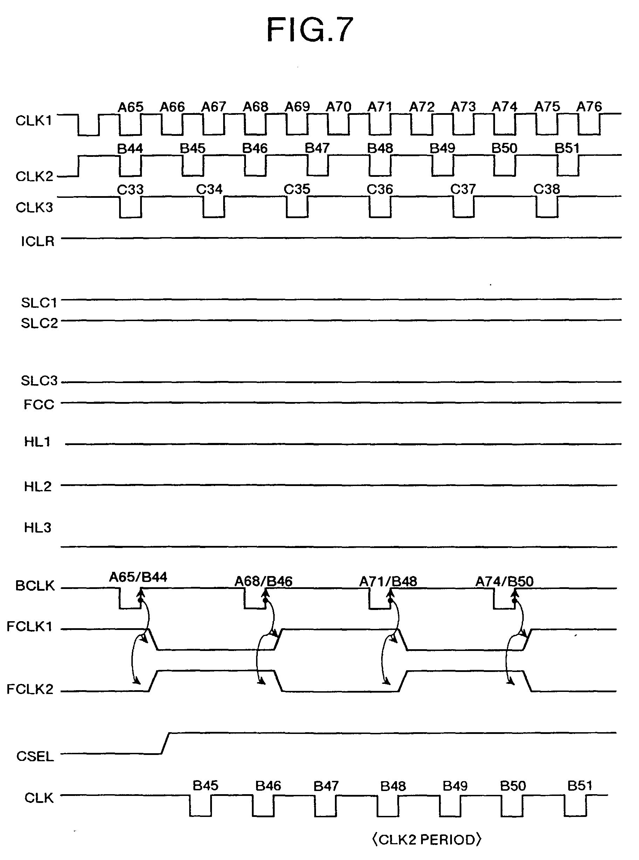

Starting of this clock signal CLK is effected after the clock selection signal CSEL rises, and from the pulse B45 of the input clock source signal CLK2 in the example in Fig. 7. The operation for clock switching is executed as described above according to the input clock selection signal SLC3 generated in response to a request from the system.

Although the above description has assumed the examples of clock switching from the input clock source signal CLK1 to the input clock source signal CLK2, of clock switching from the input clock source signal CLK2 to the input clock source signal CLK3, and of clock switching from the input clock source signal CLK3 to the input clock source signal CLK1, the same sequence is executed also in the example of clock switching from the input clock source signal CLK3 to the input clock source signal CLK2.

As described above, with the embodiment, the switching/holding circuit 2 holds a switching order of clocks according to the change in any of the clock selection signals SLC1 to SLC3, the reference clock generator 3 generates a reference clock signal BCLK according to input clock source signals before and after switching based on the switching order, the synchronizing circuit 4 synchronizes the change among the clock selection signals SLC1 to SLC3 to the reference clock signal BCLK to generate a clock selection signal CSEL, and the clock switching circuit 5 executes clock switching at a timing of generating the clock selection signal CSEL.

For this reason, an input clock source signal to be switched (which indicates the input clock source signal after the switching) and a clock selection signal CSEL indicating final clock switching are synchronized to each other, so that the stable clock switching can be realized without any abnormality in clocks. As a result, concern about malfunction and system down or the like is eliminated in the system in which the clock switching operation is executed depending on the clock switching apparatus, and for this reason, higher quality of clock switching can be realized.

The switching order of clocks is held by using the input clock selection signals SLC1 to SLC3 with the switching/holding circuit 2, so that input clock source signals before and after the switching each in synchronism with a clock selection signal generated in the operation of clock switching can securely be insured in the reference clock generator 3.

In the reference clock generator 3, a reference clock signal is generated from a plurality of input clock source signals CLK1 to CLK3 regardless of whether clocks are switched or not by the NOR circuits 301 to 303, so that a clock selection signal CSEL is prepared with some allowable time in response to change of the switching order in the synchronizing circuit 4. With this feature, the stable clock switching can be realized without delay at any time when clocks are switched.

The reference clock generator 3 obtains a reference clock signal BCLK by operating a logical sum between input clock source signals by using the NOR circuit 301 to 303, so that a clock width can be controlled so as to be made wider. With this operation, the stability on operations can be insured.

In the embodiment, although the operation for clock switching among the three types of input clock source signals CLK1 to CLK3 has been explained, the present invention is not limited to the three types thereof, and is applicable to the clock switching in which two types or four types or more of input source signals are used.

Although the invention has been described with respect to the specific embodiment for a clear and a complete disclosure, the appended claims are not to be thus limited but are to be construed as embodying all modifications and alternative constructions that may occur to one skilled in the art which fairly fall within the basic teaching herein set forth.

As described above, with the invention, a reference clock signal is generated from input clock source signals before and after switching, and clock switching is synchronized to the reference clock signal and controlled according to a timing of the operation for clock switching, so that the input clock source signal to be switched is synchronized to the timing for clock switching, and with this operation, it is possible to obtain a clock switching apparatus in which stable clock switching can be realized without any abnormality in clocks.

In an embodiment, a switching order of clocks is held according to change in input clock selection signals, a reference clock signal is generated according to input clock source signals before and after switching based on the switching order, a clock selection signal is generated by synchronizing the change in the input clock selection signals to the reference clock signal, and clock switching is executed at a timing of generating the clock selection signal, so that an input clock source signal to be switched and a clock selection signal finally generated for switching clocks are synchronized to each other, and with this operation, it is possible to obtain a clock switching apparatus in which stable clock switching can be realized without any abnormality in clocks.

In addition, the switching order of clocks is held by using input clock selection signals, so that it is possible to obtain a clock switching apparatus in which input clock source signals before and after the switching each in synchronism with a clock selection signal can securely be insured.

Preferably, an input clock selection signal before switching and an input clock selection signal after the switching are held by flip-flops, so that it is possible to obtain a clock switching apparatus in which the switching order effected at a point of current time can continuously be held until there occurs a change in the switching order.

In an embodiment, a reference clock signal is generated from a plurality of input clock source signals regardless of whether clocks are switched or not, so that a clock selection signal is prepared with some allowable time in response to change of the switching order, and with this feature, it is possible to obtain a clock switching apparatus in which stable clock switching can be realized without delay at any time when clocks are switched.

Moreover, a reference clock signal is obtained by means of a logical sum between input clock source signals, so that a clock width can be controlled so as to be made wider, and with this operation, it is possible to obtain a clock switching apparatus in which the stability on operations can be insured.

Furthermore, it is possible to obtain a clock switching apparatus in which a logical sum between each two input clock source signals can be operated by applying an OR circuit to a reference clock generator.

In addition, it is possible to obtain a clock switching apparatus in which a change among a plurality of input clock selection signals can be fetched as a pulse waveform by applying the chopper circuit.

This application is based on Japanese patent application No. HEI 9-288946 filed in the Japanese Patent Office on October 21, 1997, the entire contents of which are hereby incorporate by reference.

**Claims**

1. A clock switching apparatus for switching clocks between a plurality of input clock source signals asynchronous to each other and each having a different phase comprising:

    a circuit for generating a reference clock signal from input clock source signals before and after switching of said plurality of input clock source signals according to an operation for switching clocks, synchronizing to said generated reference clock signal, and switching a clock from said input clock source signal before switching to said input clock source signal after switching according to a timing of said operation for switching clocks.

2. A clock switching apparatus for switching clocks according to a plurality of input clock selection signals being correlated one versus one to a plurality of input clock source signals asynchronous to each other and each having a different phase; said apparatus comprising:

    a switching detector for detecting a change among said plurality of input clock selection signals according to a clock selecting operation;

a switching/holding circuit for holding a switching order among said plurality of input clock source signals according to said plurality of input clock selection signals and the change detected by said switching detector;

a reference clock generator for generating a reference clock signal according to input clock source signals before and after switching of said plurality of input clock source signals according to the switching order held by said switching/holding circuit;

a synchronizing circuit for synchronizing the change detected by said switch detector to the reference clock signal generated by said reference clock generator, and generating a clock selection signal in synchronism with the input clock source signal after the switching; and

a clock switching circuit for switching clocks from said input clock source signal before the switching to that after the switching according to the clock selection signal generated by said synchronizing circuit.

3. A clock switching apparatus according to claim 2, wherein said reference clock generator always generates one or a plurality of reference clock signals according to said plurality of input clock source signals, and selects any reference clock signal of said one or plurality of reference clock signals according to the switching order held by said switching/holding circuit.

4. A clock switching apparatus according to claim 3, wherein said reference clock generator computes a logical sum between each two input clock source signals among said plurality of input clock source signals to generate said one or plurality of reference clock signals.

5. A clock switching apparatus according to claim 4, wherein said reference clock generator comprises an OR circuit for computing a logical sum between each two input clock source signals.

6. A clock switching apparatus according to claim 2, 3, 4, or 5, wherein said switching/holding circuit holds, of said plurality of input clock selection signals, an input clock selection signal before switching and an input clock selection signal after the switching as a switching order.

7. A clock switching apparatus according to claim 6, wherein said switching/holding circuit comprises a flip-flop for holding an input clock selection signal before switching and an input clock selection signal after the switching.

8. A clock switching apparatus according to any of claims 2 to 7, wherein said switching detector comprises a chopper circuit for forming a pulse waveform according to a change in said plurality of input clock selection signals.

FIG.1

EP 0 911 971 A1

# FIG.2

# FIG.3

〈CLK2 PERIOD〉

# FIG.4

# FIG.5

# FIG.6

〈CLK1 PERIOD〉

# FIG.7

⟨CLK2 PERIOD⟩

FIG.8

# FIG.9

EP 0 911 971 A1

**European Patent Office**

**EUROPEAN SEARCH REPORT**

Application Number

EP 98 30 3807

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 294 842 A (WATSON JR RICHARD B ET AL) 15 March 1994<br>* column 6, line 44 - column 9, line 46; figures 5,7,8 *<br>--- | 1-8 | H03K5/135 |
| X | US 5 623 223 A (PASQUALINI RONALD) 22 April 1997<br>* column 2, line 29 - column 6, line 49; figures 1,2 *<br>--- | 1-3,6,7 | |
| X | US 4 419 629 A (O'BRIEN STEVEN M) 6 December 1983<br>* the whole document *<br>--- | 1-3,6,7 | |
| X | PATENT ABSTRACTS OF JAPAN<br>vol. 013, no. 488 (P-954), 7 November 1989<br>-& JP 01 194014 A (TOSHIBA CORP), 4 August 1989<br>* abstract *<br>----- | 1-3,6,7 | TECHNICAL FIELDS SEARCHED (Int.Cl.6)<br><br>H03K<br>G06F |

The present search report has been drawn up for all claims

| Place of search | Date of completion of the search | Examiner |
|---|---|---|
| MUNICH | 18 November 1998 | Moll, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

## EP 0 911 971 A1

**ANNEX TO THE EUROPEAN SEARCH REPORT
ON EUROPEAN PATENT APPLICATION NO.**                EP 98 30 3807

This annex lists the patent family members relating to the patent documents cited in the above-mentioned European search report.
The members are as contained in the European Patent Office EDP file on
The European Patent Office is in no way liable for these particulars which are merely given for the purpose of information.

18-11-1998

| Patent document cited in search report | | Publication date | Patent family member(s) | | Publication date |
|---|---|---|---|---|---|
| US 5294842 | A | 15-03-1994 | WO 9306657 A<br>WO 9306544 A<br>WO 9306497 A | | 01-04-1993<br>01-04-1993<br>01-04-1993 |
| US 5623223 | A | 22-04-1997 | NONE | | |
| US 4419629 | A | 06-12-1983 | JP 57079538 A | | 18-05-1982 |

EPO FORM P0459

For more details about this annex : see Official Journal of the European Patent Office, No. 12/82